# EUROPÄISCHE PATENTANMELDUNG

(11) **EP 1 648 086 A1**
(43) Veröffentlichungstag der Anmeldung: **19.04.2006**
(21) Anmeldenummer: 05017562.9
(22) Anmeldetag: 12.08.2005
(51) Int. Cl.: H03K 17/06, H03K 17/10

(54) **Integrierte Schaltungsanordnung zur Ansteuerung von Leistungshalbleiterschaltern**

(30) Priorität: 13.10.2004 DE 102004049817
(71) Anmelder: Semikron Elektronik GmbH & Co. KG Patentabteilung, 90431 Nürnberg (DE)
(72) Erfinder: Herzer, Reinhard, Dr., 98693 Ilmenau (DE); Stockmeier, Thomas, Dr., 90431 Nürnberg (DE)

(57) **Zusammenfassung**

Es wird eine Integrierte Schaltungsanordnung zur Ansteuerung von einzelnen Leistungshalbleiterschaltern oder Leistungshalbleiterschaltern in Halbbrückenanordnung vorgestellt. Die Schaltungsanordnung besteht aus einem ersten integrierten Ansteuerchip (72) mit einer Mehrzahl von Funktionsgruppen mindestens umfassend einen ersten Levelshifter (730) für einen Schalter (40) auf höherem Potential und mindestens einem zweiten integrierten Ansteuerchip (74) mit einer Mehrzahl von Funktionsgruppen mindestens umfassend einen zweiten Levelshifter (740) und einen Treiber (746) für diesen Schalter. Hierbei ist der mindestens eine zweite Ansteuerchip (74) dem ersten (72) nachgeschaltet, das Grundpotential des zweiten Ansteuerchips (74) befindet sich auf dem Ausgangspotential des Levelshifters (730) des ersten Ansteuerchips (72) und die Ansteuerchips (72,74) sind in einem gemeinsamen Gehäuse mit geeigneter Isolierung der Ansteuerchips (72,74) gegeneinander angeordnet.

## Beschreibung

Es wird eine integrierte Schaltungsanordnung vorgestellt zur Ansteuerung von Leistungshalbleiterschaltern angeordnet als Einzelschalter oder in einer Brückenschaltung. Derartige Brückenanordnungen von Leistungsschaltern sind als Ein-, Zwei-, oder Dreiphasen- Halbbrückenschaltungen bzw. als H- Brückenschaltungen bekannt, wobei die einphasige Halbbrücke einen Grundbaustein leistungselektronischer Schaltungen darstellt. In einer Halbbrückenschaltung sind zwei Leistungsschalter, ein erster, sog. TOP- Schalter und ein zweiter sog. BOT- Schalter in einer Reihenschaltung angeordnet. Eine derartige Halbbrücke weist in der Regel eine Verbindung zu einem Gleichstromzwischenkreis auf. Die Mittelanzapfung ist typischerweise mit einer Last verbunden.

Bei Ausgestaltung der Leistungsschalter mit einem Leistungshalbleiterbauelement oder mit einer Mehrzahl gleichartiger in Reihe geschalteter Leistungshalbleiterbauelemente ist zur Ansteuerung der Leistungsschalter eine Ansteuerschaltung notwendig. Diese Ansteuerschaltungen bestehen in der Regel nach dem Stand der Technik aus mehreren Teilschaltungen bzw. Funktionsblöcken. Das von einer übergeordneten Steuerung kommende Ansteuersignal wird in einer ersten Teilschaltung, der Ansteuerlogik, aufbereitet und über weitere Komponenten den Treiberschaltungen und schließlich dem Steuereingang des jeweiligen Leistungsschalters zugeführt. Bei Halbbrückenanordnungen mit höheren Zwischenkreisspannungen, beispielhaft größer 100V, wird die Ansteuerlogik zur Aufbereitung der Steuersignale potentialmäßig / galvanisch von den Treiberschaltungen getrennt, da sich die zugehörigen Leistungsschalter untereinander auf unterschiedlichem Potential befinden und somit eine spannungsmäßige Isolation unumgänglich wird. Diese Trennung erfolgt nach dem Stand der Technik beispielhaft mittels Übertragern, Optokopplern bzw. Lichtwellenleitern. Diese galvanische Trennung gilt zumindest für den TOP-Schalter, wird aber bei höheren Leistungen auch für den BOT- Schalter auf Grund eines möglichen Verrisses des Massepotentials beim Schalten ausgeführt.

Bekannt sind auch integrierte Schaltungsanordnungen für Leistungsschalter der Spannungsklassen bis 600V, die auf eine externe galvanische Trennung verzichten. Dies sind monolithisch integrierte Schaltungen, wobei nach dem Stand der Technik Levelshifter beispielhaft in sog. SOI- (silicon on isolator) Technologie zur galvanischen Trennung der Ansteuerlogik von der eigentlichen Treiberschaltung eingesetzt werden. Für höhere Spannungsklassen steht diese Technologie technisch eingeschränkt und nur zu hohen Kosten zur Verfügung.

Weiterhin bekannt ist die monolithische Integration der Ansteuerlogik, sowie der Treiberschaltungen mittels "junction isolation". Diese Technik steht bis zur Spannungsklasse von 1200V zur Verfügung. Eine derartige Ausgestaltung der integrierten Schaltungsanordnung ist allerdings herstellungstechnisch sehr aufwändig und somit ebenso kostenintensiv. Weiterhin gibt es technische Probleme, beispielhaft mit Leckströmen und Latch-up Effekten u.a. bei höheren Temperaturen (>125°C Betriebstemperatur) sowie durch Verriß des Massepotentials bei schnellen dynamischen Vorgängen.

Der Erfindung liegt die Aufgabe zugrunde eine integrierte Schaltungsanordnung vorzustellen, die bekannte Herstellungstechnologien verwendet und dabei für höhere Spannungsklassen einsetzbar ist als dies mit diesen Herstellungstechnologien üblich ist und gleichzeitig auch zum Einsatz bei höheren Betriebstemperaturen über 125°C geeignet ist.

Die Aufgabe wird erfindungsgemäß gelöst, durch die Maßnahmen der Merkmale der Ansprüche 1 oder 2. Bevorzugte Ausführungsformen sind in den Unteransprüchen beschrieben.

Die erfindungsgemäße integrierte Schaltungsanordnung dient der Ansteuerung von Leistungshalbleiterschaltern angeordnet als Einzelschalter oder in einer Brückenschaltung. Die Brückenschaltung ist hierbei die geläufigere Anwendung, daher wird im Folgenden hauptsächlich hierauf eingegangen. In Brückenschaltungen sind der TOP- und BOT- Schalter in Reihe geschaltet und mit einem Gleichstromzwischenkreis und einer Last verbunden. Die Brückenschaltung kann hierbei verschieden ausgestaltet sein, beispielsweise als ein-, zwei- oder dreiphasige Halbbrücke oder auch als Dreiphasenbrücke mit einem weiteren Leistungsschalter, dem sog. Bremschopper. Abhängig von der Ausgestaltung der Brückenschaltung weist die erfindungsgemäße integrierte Schaltungsanordnung einen ersten integrierten Ansteuerchip und mindestens einen zweiten integrierten Ansteuerchip auf. Der erste Ansteuerchip beinhaltet eine Mehrzahl von Funktionsgruppen, darunter die Ansteuerlogik und mindestens einen Treiber eines BOT-Schalters und mindestens einen ersten Levelshifter für einen TOP- Schalter. Der mindestens eine zweite integrierte Ansteuerchip enthält eine Mehrzahl von Funktionsgruppen darunter erfindungsgemäß mindestens einen zweiten Levelshifter und einen Treiber eines TOP- Schalters. Erfindungsgemäß ist der mindestens eine zweite Ansteuerchip dem ersten nachgeschaltet. Hierbei liegt das Grundpotential des jeweiligen zweiten Ansteuerchips auf dem Ausgangspotential des Levelshifters des ersten Ansteuerchips für den entsprechenden TOP- Schalter. Der erste und der mindestens eine zweite Ansteuerchip sind vorteilhafterweise in einem gemeinsamen Gehäuse mit geeigneter Isolierung aller Ansteuerchips gegeneinander angeordnet.

Im Falle der Ansteuerung eines Einzelschalters ist selbstverständliche kein Treiber für einen BOT- Schalter in der Schaltungsanordnung vorhanden sondern ausschließlich der oder die Levelshifter für den oder die auf anderem Potential liegenden Leistungsschalter.

Der erfinderische Gedanke wird anhand der Ausführungsbeispiele in den Fig. 1 bis 4 näher erläutert.

Fig. 1 zeigt eine Schaltungsanordnung zur Ansteuerung von Leistungshalbleiterschaltern nach dem Stand der Technik.

Fig. 2 zeigt eine erfindungsgemäße Schaltungsanordnung zur Ansteuerung von Leistungshalbleiterschaltern für eine Halbbrückenschaltung der Leistungsschalter.

Fig. 3 zeigt eine erfindungsgemäße Schaltungsanordnung zur Ansteuerung von Leistungshalbleiterschaltern für eine Dreiphasenbrückenschaltung der Leistungsschalter.

Fig. 4 zeigt eine erfindungsgemäße Schaltungsanordnung zur Ansteuerung von Leistungshalbleiterschaltern für eine Dreiphasenbrückenschaltung mit Bremschopper.

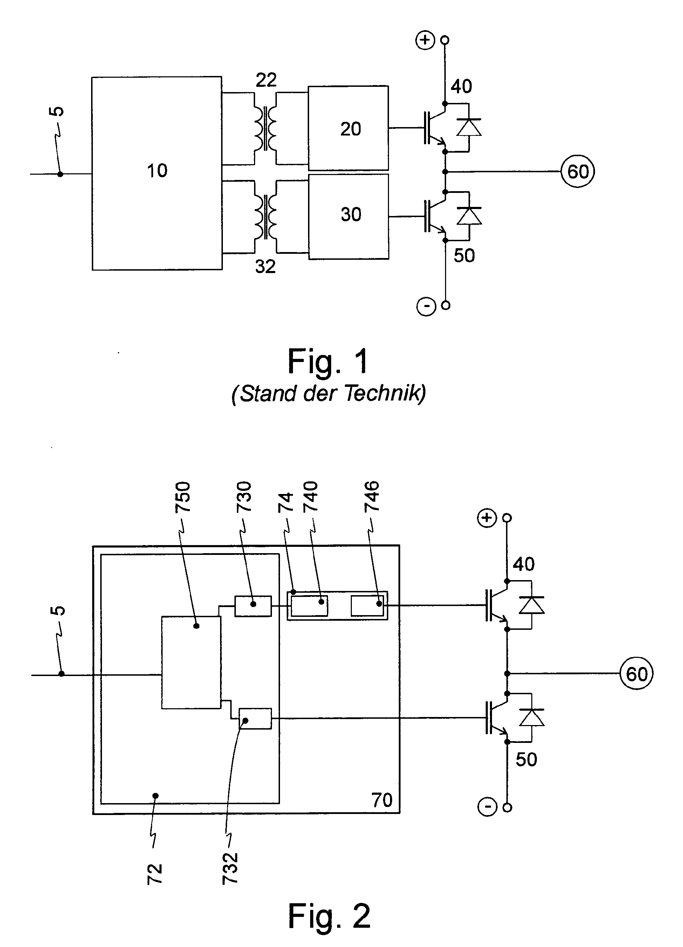

Fig. 1 zeigt eine Schaltungsanordnung zur Ansteuerung von Leistungshalbleiterschaltern nach dem Stand der Technik. Dargestellt ist eine Halbbrückenschaltung bestehend aus einem ersten Leistungsschalter (40), dem TOP-Schalter und einem in Reihe hierzu angeordneten zweiten Leistungsschalter (50), dem BOT- Schalter. Beide Schalter bestehen ihrerseits aus jeweils einem Leistungstransistor beispielhafte einem IGBT (insulated gate bipolar transistor) und einer antiparallel geschalteten Freilaufdiode oder alternativ hierzu einem MOS-FET. Dem Stand der Technik entsprechend kann der jeweilige Leistungsschalter auch aus einer Mehrzahl parallel geschalteter IGBTs und einer Mehrzahl antiparallel hierzu geschalteter Freilaufdioden bzw. analog eine Mehrzahl von MOS-FETs bestehen.

Die Steuereingänge, die Gates der jeweiligen Transistoren sind mit einer Treiberschaltung verbunden. Dem TOP- Schalter (40) ist hierbei die Treiberschaltung (20) und dem BOT- Schalter (50) die Treiberschaltung (30) zugeordnet. Die beiden Leistungsschalter liegen im Betrieb auf unterschiedlichem Potential, daher müssen die beiden Treiberschaltungen (20, 30) elektrisch isoliert voneinander angeordnet sein.

Die Ansteuersignale (5) einer übergeordneten Steuerung werden in der Ansteuerlogikschaltung (10) aufbereitet und galvanisch getrennt zu den Treiberschaltungen übertragen. Zur galvanische Trennung sind hierbei zwischen der Ansteuerlogik (10) und den Treiberschaltungen (20, 30) die Übertrager (22, 32) geschaltet. In bestimmten Anwendungsfällen, beispielhaft bei kleinen Leistungen, wird nach dem Stand der Technik auf den Übertrager (32) zum Treiber (30) des BOT- Schalters (50) verzichtet. Dann befinden sich die Ansteuerlogik (10) und der BOT- Treiber (30) auf dem gleichen Potential.

Fig. 2 zeigt eine erfindungsgemäße Schaltungsanordnung zur Ansteuerung von Leistungshalbleiterschaltern für eine Halbbrückenschaltung dieser Leistungsschalter. Die Halbbrückenschaltung ist identisch derjenigen in Fig. 1. Als Leistungsschalter (40, 50) sind hier IGBTs der Spannungsklasse 1200V vorgesehen.

Die Ansteuersignale (5)der übergeordneten Steuerung werden erfindungsgemäß von einem einzigen Baustein verarbeitet und den Gates der jeweiligen Leistungsschalter (40, 50) zugeführt. Der Baustein besteht seinerseits aus zwei Ansteuerchips (72, 74), die gegeneinander isoliert in einem gemeinsamen Gehäuse (70) angeordnet sind. Der erste Ansteuerchip (72) umfasst eine Logikbaugruppe (750), einen Treiber (732) für den BOT-Schalter (50) sowie einen ersten Levelshifter (730) für einen TOP- Schalter. Der Ausgang dieses Levelshifters ist mit dem Eingang des zweiten Ansteuerchips (74) verbunden. Dieser umfasst einen zweiten Levelshifter (740) sowie den Treiber (746) des TOP- Schalters (40).

Das Signal zwischen der Logikbaugruppe (750) und dem Treiber (746) des TOP-Schalters (40) wird somit mittels zweiter Levelshifter (730, 740) auf das notwendige Potential angehoben. Da der erste Levelshifter (730) integraler Bestandteil des ersten Ansteuerchips (72) ist und der zweite Levelshifter (740) integraler Bestandteil des zweiten Ansteuerchips (74) ist, muss auf jedem Ansteuerchip (72, 74) nur die halbe maximale Spannung als Potentialdifferenz überwunden werden. Hierbei kann das Grundpotential des ersten Ansteuerchips (72) beispielhaft zwischen 0V und 600V und das des zweiten Ansteuerchips (74) zwischen 600V und 1200V schwanken. Somit können 600V-Isolationsverfahren nach dem Stand der Technik, beispielhaft SOI, auf dem jeweiligen Ansteuerchip (72, 74) eingesetzt werden. Da beide Ansteuerchips (72, 74) gegeneinander isoliert angeordnet sind, wird somit die doppelte Potentialdifferenz verglichen mit der Potentialdifferenz des jeweiligen Ansteuerchips (72, 74) in der gesamten integrierten Schaltungsanordnung überwunden. Im Ausführungsbeispiel wird mit einer internen Isolierung innerhalb der Ansteuerchips (72, 74) von 600V, eine erfindungsgemäße integrierte Schaltungsanordnung (70) für die Spannungsklasse von 1200V realisiert.

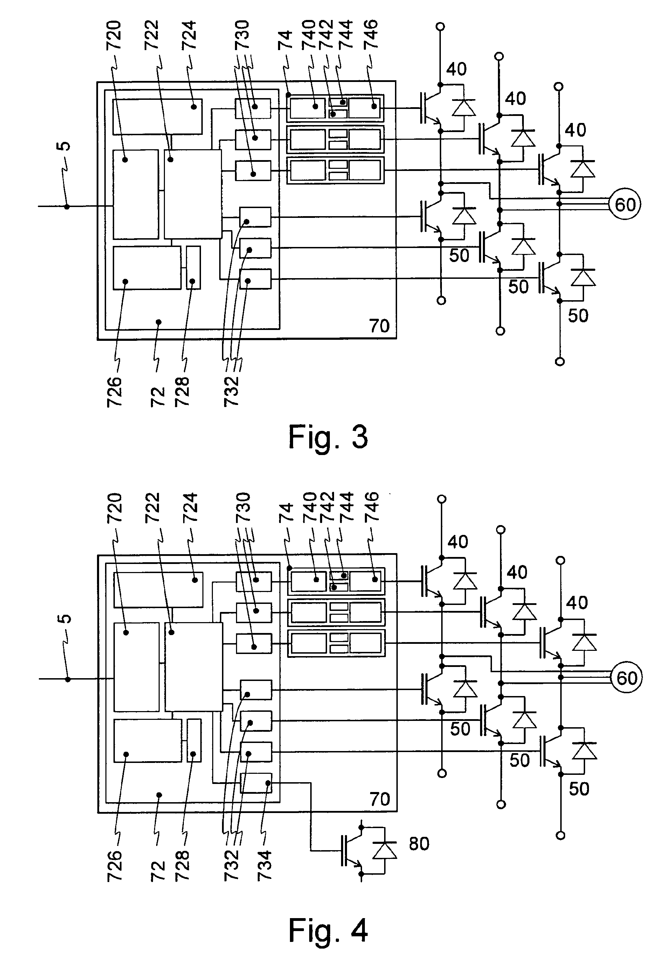

Fig. 3 zeigt eine erfindungsgemäße Schaltungsanordnung zur Ansteuerung von Leistungshalbleiterschaltern für eine Dreiphasenbrückenschaltung der Leistungsschalter. Die Dreiphasenbrückenschaltung ist aus drei Halbbrückenschaltungen identisch derjenigen in Fig. 1 aufgebaut. Die Dreiphasenbrückenschaltung weist jeweils drei TOP- sowie drei BOT- Schalter auf, die ebenfalls als IGBTs der Spannungsklasse 1200V ausgebildet sind. Die Last (60) kann beispielhaft als Drehstrom- Elektromotor ausgebildet sein.

Die Ansteuersignale (5) der übergeordneten Steuerung werden erfindungsgemäß von einem einzigen Baustein (70) verarbeitet und den Gates der jeweiligen Leistungsschalter (40, 50) der Dreiphasenbrückenschaltung zugeführt. Der Baustein (70) besteht seinerseits aus vier Ansteuerchips (72, 74), die gegeneinander isoliert in einem gemeinsamen Gehäuse (70) angeordnet sind. Der erste Ansteuerchip (72) ist hier in einer höheren Komplexität verglichen mit Fig. 2 dargestellt und umfasst die Funktionsgruppen Spannungsregler (724) Eingangsinterface (720), Verarbeitungslogik (722), Fehlermanagement (726) und Schutzschaltung (728) sowie drei Treiber (732) für die BOT-Schalter (50) und drei Levelshifter (730) für die TOP- Schalter (40) der Dreiphasenbrückenschaltung. Die Ausgänge der Levelshifter (730) sind mit den Eingängen von drei zweiten Ansteuerchips (74) verbunden. Diese umfassen jeweils einen Levelshifter (740), eine Signalrekonstruktion (742), eine Verarbeitungslogik und eine Schutzschaltung (744) sowie den Treiber (746) des jeweiligen TOP- Schalters (40).

Das Signal zwischen der Verarbeitungslogik (722) und dem Treiber (746) des TOP-Schalters (40) wird wiederum mittels zweiter Levelshifter (730, 740) auf das notwendige Potential angehoben. Der erste Levelshifter (730) ist integraler Bestandteil des ersten Ansteuerchips (72) und der zweite Levelshifter (740) integraler Bestandteil des jeweiligen zweiten Ansteuerchips (74), wobei das Ausgangspotential der jeweiligen zweiten Ansteuerchips (74) im Betrieb auf unterschiedlichem Potential zwischen 600V und 1200V liegen und dieses Potential während der Betriebszeit schwankend ist. Auch im Fall der Ansteuerung einer Dreiphasenbrückenschaltung können Isolationsverfahren nach dem Stand der Technik auf dem jeweiligen Ansteuerchip (72, 74) eingesetzt werden. Da alle Ansteuerchips (72, 74) gegeneinander isoliert angeordnet sind kann somit ebenfalls wie im Ausführungsbeispiel gemäß Fig. 2 die doppelte Potentialdifferenz, verglichen mit der Potentialdifferenz innerhalb eines Ansteuerchips (72, 74) in der gesamten integrierten Schaltungsanordnung (70) überwunden werden.

Fig. 4 zeigt eine erfindungsgemäße Schaltungsanordnung zur Ansteuerung von Leistungshalbleiterschaltern für eine Dreiphasenbrückenschaltung mit Bremschopper. Hierbei ist ein siebter Leistungsschalter (80) zusätzliche zu den drei TOP-, und den drei BOT- Schaltern (50) angeordnet. Dieser siebte Schalter (80) dient im Betrieb als Steuerung für einen sog. Bremschopper, welcher der Abführung überschüssiger elektrischer Energie in einer Schaltung beispielhaft aus der Rückspeisung des Elektromotors (60) dient. Zur Ansteuerung des Leistungsschalters (80) für den Bremschopper weist der erste Ansteuerchip gegenüber demjenigen gemäß Fig. 3 einen weiteren Treiber (734) auf, der auf dem gleichen Potential wie die Treiber (732) der BOT- Schalter (50) liegt.

## Patentansprüche

1. Integrierte Schaltungsanordnung zur Ansteuerung von Leistungshalbleiterschaltern (40),
wobei die Schaltungsanordnung aus einem ersten integrierten Ansteuerchip (72) mit einer Mehrzahl von Funktionsgruppen besteht mindestens umfassend mindestens einen ersten Levelshifter (730) für einen Schalter (40),
und mindestens einem zweiten integrierten Ansteuerchip (74) mit einer Mehrzahl von Funktionsgruppen mindestens umfassend einen zweiten Levelshifter (740) und einen Treiber (746) eines Schalters (40),
wobei der mindestens eine zweite Ansteuerchip (74) dem ersten (72) nachgeschaltet ist, sich das Grundpotential des zweiten Ansteuerchips (74) auf dem Ausgangspotential des Levelshifters (730) des ersten Ansteuerchips (72) befindet und die Ansteuerchips (72, 74) in einem gemeinsamen Gehäuse (70) mit geeigneter Isolierung der Ansteuerchips (72, 74) gegeneinander angeordnet sind.

2. Integrierte Schaltungsanordnung zur Ansteuerung von Leistungshalbleiterschaltern (40, 50) angeordnet in einer Brückenschaltung als TOP- (40) und BOT- (50) Schalter verbunden mit einem Gleichstromzwischenkreis und einer Last (60),
wobei die Schaltungsanordnung aus einem ersten integrierten Ansteuerchip (72) mit einer Mehrzahl von Funktionsgruppen besteht mindestens umfassend einen Treiber (732) eines BOT- Schalters (50) und mindestens einen ersten Levelshifter (730) für einen TOP- Schalter (40),
und mindestens einem zweiten integrierten Ansteuerchip (74) mit einer Mehrzahl von Funktionsgruppen mindestens umfassend einen zweiten Levelshifter (740) und einen Treiber (746) eines TOP- Schalters (40),
wobei der mindestens eine zweite Ansteuerchip (74) dem ersten (72) nachgeschaltet ist, sich das Grundpotential des zweiten Ansteuerchips (74) auf dem Ausgangspotential des Levelshifters (730) des ersten Ansteuerchips (72) befindet und die Ansteuerchips (72, 74) in einem gemeinsamen Gehäuse (70) mit geeigneter Isolierung der Ansteuerchips (72, 74) gegeneinander angeordnet sind.

3. Schaltungsanordnung nach Anspruch 1 oder 2,
wobei ein Leistungshalbleiterschalter (40, 50) ein oder eine Mehrzahl gleichartiger Leistungshalbleiterbauelemente wie IGBTs mit antiparallel dazu angeordneter Freilaufdiode oder MOSFETs aufweist.

4. Schaltungsanordnung nach Anspruch 1 oder 2,
wobei der erste integrierte Ansteuerchip (72) die weiteren Funktionsgruppen Spannungsregler (724), Eingangsinterface (720), Verarbeitungslogik (722), Fehlermanagement (726)und Schutzschaltung (728) aufweist.

5. Schaltungsanordnung nach Anspruch 1 oder 2,
wobei ein zweiter integrierter Ansteuerchip (74) die weiteren Funktionsgruppen Signalrekonstruktion (742), Verarbeitungslogik und Schutzschaltung (744) aufweist.

6. Schaltungsanordnung nach Anspruch 1 oder 2,
wobei das Ausgangspotential des ersten Levelshifters (730) zwischen 0 und 600V oberhalb des Grundpotential des ersten integrierten Ansteuerchips (72) variiert.

7. Schaltungsanordnung nach Anspruch 2,
wobei die Schaltungsanordnung zur Ansteuerung der Leistungshalbleiterschalter (40, 50) einer Halbbrückenschaltungsanordnung bestehend aus je einem TOP- und einem BOT- Schalter einen ersten (72) und einen zweiten (74) Ansteuerchip aufweist.

8. Schaltungsanordnung nach Anspruch 2,
wobei die Schaltungsanordnung zur Ansteuerung der Leistungshalbleiterschalter (40, 50) einer 3-Phasen Brückenschaltungsanordnung einen ersten Ansteuerchip (72) mit drei BOT- Treibern (732) und drei Levelshiftern (730) sowie drei zweite Ansteuerchips (74) mit jeweils einem Levelshifter (740) und einem TOP-Treiber (746) aufweist.

9. Schaltungsanordnung nach Anspruch 2,
wobei die Schaltungsanordnung zur Ansteuerung der Leistungshalbleiterschalter (40, 50) einer 3-Phasen Brückenschaltungsanordnung mit Bremschopper einen ersten Ansteuerchip (72) mit drei BOT- Treibern (732), einem Treiber (734) eines weiteren Schalters (80) für einen Bremschopper und drei Levelshiftern (730) sowie drei zweite Ansteuerchips (74) mit jeweils einem Levelshifter (740) und einem TOP-Treiber (746) aufweist.
